# FASCICULE DE BREVET EUROPEEN

(11) **EP 4 521 449 B1**
(45) Date de publication et mention de la délivrance du brevet: **05.11.2025**
(21) Numéro de dépôt: 24198761.9
(22) Date de dépôt: 05.09.2024
(51) Int. Cl.: H01L 21/60, H01L 23/485

(54) **PROCÉDÉ DE FABRICATION D'UNE PUCE ÉLECTRONIQUE COMPRENANT DES PILIERS DE CONNEXION POUR UN ASSEMBLAGE PAR FRITTAGE**
VERFAHREN ZUR HERSTELLUNG EINES HALBLEITERCHIPS MIT SÄULENVERBINDERN FÜR SINTERMONTAGE
METHOD OF MANUFACTURING AN ELECTRONIC CHIP COMPRISING PILLAR ELECTRODES FOR SINTER CONNECTION

(30) Priorité: 08.09.2023 FR 2309488
(43) Date de publication de la demande: 12.03.2025
(73) Titulaire: Commissariat à l'Energie Atomique et aux Energies Alternatives, 75015 Paris (FR); Centre National de la Recherche Scientifique, 75794 Paris Cedex 16 (FR); UNIVERSITE DE BORDEAUX, 33000 Bordeaux (FR); Institut Polytechnique De Bordeaux, 33402 Talence (FR)
(72) Inventeur: FEAUTRIER, Céline, 38054 GRENOBLE CEDEX 09 (FR); SOURIAU, Jean-Charles, 38054 GRENOBLE CEDEX 09 (FR); GOUGEON, Julie, 38054 GRENOBLE CEDEX 09 (FR); TREGUER-DELAPIERRE, Mona, 33140 VILLENAVE D'ORNON (FR)
(74) Mandataire: Cabinet Beaumont

(56) Documents cités:
- JP-A- 2007 335 464
- US-A1- 2010 148 374
- US-B2- 11 094 655
- US-B2- 8 723 318

## Description

### Domaine technique

La présente description concerne le domaine de la connexion électrique entre une puce électronique et un boîtier ou entre deux puces électroniques, et plus particulièrement des piliers de connexion de la puce électronique.

### Technique antérieure

Dans une puce électronique, les connexions sont faites par des réseaux d'interconnexion internes. Pour connecter une puce de circuit intégré à un élément extérieur, ces réseaux d'interconnexion sont connectés à des piliers, généralement situés sur une face de la puce. Ainsi, il est possible de mettre en contact les piliers avec des zones conductrices ou des pistes de connexion situées sur cet autre élément. L'élément peut correspondre à un substrat, également appelé boîtier notamment dans le domaine de l'électronique de puissance, par exemple un circuit imprimé. L'élément peut en outre correspondre à une autre puce électronique.

Un exemple de procédé d'assemblage d'une puce électronique à une autre puce électronique ou un boîtier comprend la formation d'un bloc de pâte à fritter sur chaque pilier, le dépôt de la puce électronique sur l'autre puce électronique ou le boîtier, et le frittage de la pâte à fritter. Pour certaines applications, le frittage est mis en oeuvre à une température inférieure à 200 °C et sans l'exercice d'une pression sur la puce électronique. Pour de telles applications, l'étape de dépôt de la puce électronique sur l'autre puce électronique ou le boîtier est réalisée avant le séchage de la pâte à fritter.

Les documents US 8 723 318 B et US 11 094 655 B décrivent des structures de piliers selon l'état de la technique.

### Résumé de l'invention

Un mode de réalisation pallie tout ou partie des inconvénients des puces électroniques comprenant des piliers de connexion connues.

Un mode de réalisation prévoit une puce électronique comprenant un support et des piliers de connexion, chaque pilier de connexion comprenant un tronc comportant une portion d'extrémité et une portion intermédiaire reliant la portion d'extrémité au support et comprenant une collerette à la jonction entre la portion d'extrémité et la portion intermédiaire.

Selon un mode de réalisation, la hauteur de la portion d'extrémité est comprise entre 10 µm et 100 µm.

Selon un mode de réalisation, la hauteur de la portion intermédiaire est comprise entre 10 µm et 100 µm.

Selon un mode de réalisation, l'écart entre la dimension latérale maximale de la collerette et la dimension latérale minimale de la portion d'extrémité est compris entre 1 µm et 7 µm.

Selon un mode de réalisation, la portion d'extrémité comprend une face d'extrémité du côté opposé à la portion intermédiaire.

Selon un mode de réalisation, la portion d'extrémité a une forme évasée du côté de la face d'extrémité.

Selon un mode de réalisation, le pilier de connexion comprend une couche de finition recouvrant la face d'extrémité.

Selon un mode de réalisation, le tronc est en cuivre.

Un mode de réalisation prévoit également un procédé d'assemblage d'une puce électronique telle que définie précédemment à une autre puce électronique ou à un boîtier, comprenant la pénétration des piliers de connexion dans une couche de pâte à fritter au moins jusqu'à la collerette de chaque pilier de connexion, le retrait des piliers de connexion de la couche de pâte à fritter, un bloc de pâte à fritter restant accroché à chaque pilier de connexion, le dépôt de la puce électronique sur l'autre puce électronique ou sur le boîtier et le chauffage pour obtenir le frittage des blocs de pâte à fritter.

Un mode de réalisation prévoit également un procédé de fabrication d'une puce électronique telle que définie précédemment, comprenant la formation d'un premier masque en résine photosensible comprenant, pour chaque pilier de connexion, une première ouverture traversante, le dépôt du matériau composant le tronc dans les premières ouvertures traversantes, la formation d'un deuxième masque en résine photosensible comprenant une deuxième ouverture traversante dans le prolongement de chaque première ouverture traversante, et le dépôt du matériau composant le tronc dans les deuxièmes ouvertures traversantes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, schématiquement, un mode de réalisation d'un pilier de connexion d'une puce ;
la figure 2, la figure 3, et la figure 4 représentent chacune, schématiquement, un autre mode de réalisation d'un pilier de connexion ;
la figure 5 et la figure 6 sont chacune une image obtenue par microscopie électronique à balayage du pilier de connexion de la figure 1 ;
la figure 7, la figure 8, la figure 9, et la figure 10 représentent des structures obtenues à des étapes successives d'un mode de réalisation d'un procédé d'assemblage de la puce de la figure 1 à une autre puce ou à un boîtier ;
la figure 11 est une image obtenue par microscopie électronique à balayage du pilier de connexion de la figure 1 à l'étape du procédé d'assemblage illustré en figure 9 ;
la figure 12 est une image obtenue par microscopie électronique à balayage d'une coupe de la structure obtenue à l'étape du procédé d'assemblage illustré en figure 10 ; et
la figure 13, la figure 14, la figure 15, la figure 16, la figure 17, la figure 18, la figure 19, et la figure 20 représentent des structures obtenues à des étapes successives d'un mode de réalisation d'un procédé de fabrication de la puce de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les divers composants des puces, ainsi que les connexions internes des puces, ne sont pas détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, on considère ici que les termes "isolant" et "conducteur" signifient respectivement "isolant électriquement" et "conducteur électriquement".

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un circuit électronique dans une position normale d'utilisation.

Sauf précision contraire, les expressions "environ", "approximativement", "sensiblement", et "de l'ordre de" signifient à 10 % près, de préférence à 5 % près.

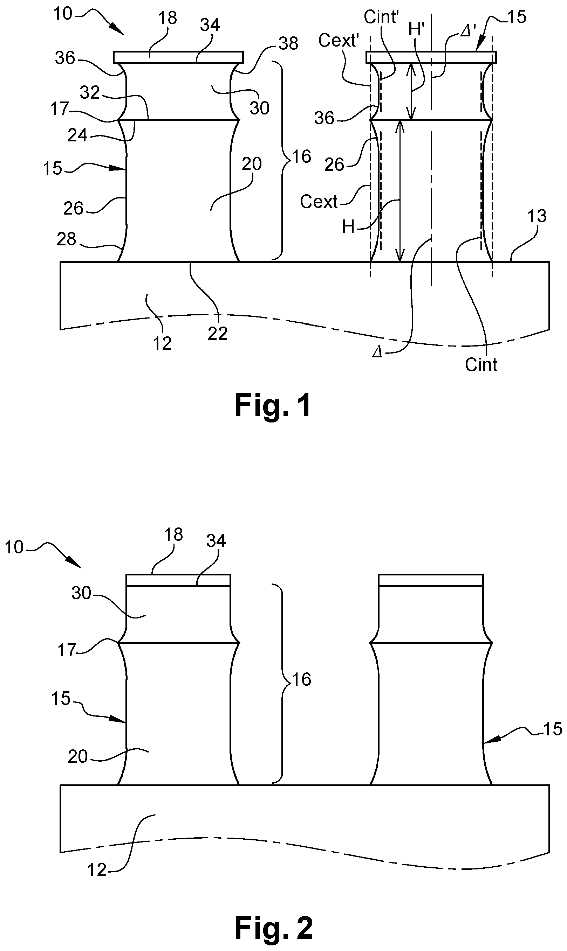

La figure 1 est une vue de côté, partielle et schématique, d'un mode de réalisation d'une puce électronique 10 que l'on souhaite connecter à un boîtier ou une autre puce électronique, non représentée. La puce 10 comprend des piliers de connexion 15, également appelés plots de connexion, en un matériau conducteur. Bien que deux piliers de connexion 15 soient représentés en figure 1, la puce 10 comprend autant de piliers de connexion 15 que de connexions à faire (selon l'application visée, seuls deux, plusieurs dizaines, voire plusieurs milliers de piliers de connexion 15 peuvent être présents). La puce 10 comprend par exemple un support 12 ayant une face 13 sur laquelle sont réalisées les connexions électriques avec l'extérieur de la puce 10. A titre d'exemple, le support 12 comprend un substrat, par exemple en silicium, recouvert d'une structure d'interconnexion comprenant des éléments conducteurs non représentés, par exemple des vias et des métallisations. Chaque pilier de connexion 15 est par exemple connecté électriquement à de tels éléments conducteurs.

Chaque pilier 15 comprend un tronc 16 ayant une portion intermédiaire 20 et une portion d'extrémité 30. La portion intermédiaire 20 est située entre le support 10 et la portion d'extrémité 30. Le pilier 15 comprend une collerette 17 à la jonction entre la portion intermédiaire 20 et la portion d'extrémité 30. La portion intermédiaire 20 comprend une base 22, une face de liaison 24 opposée à la base 22, et une paroi latérale 26 reliant la base 22 à la face de liaison 24. La portion d'extrémité 30 comprend une face de liaison 32, une face d'extrémité 34 opposée à la face de liaison 32, et une paroi latérale 36 reliant la face de liaison 32 à la face d'extrémité 34. La base 22 de la portion intermédiaire 20 est au contact physique direct du support 12. La face de liaison 24 de la portion intermédiaire 20 est confondue avec la face de liaison 32 de la portion d'extrémité 30. Selon un mode de réalisation, la paroi latérale 36 de portion d'extrémité 30 comprend en outre une partie évasée 38 du côté de la face supérieure 32. Selon un mode de réalisation, la paroi latérale 26 de portion intermédiaire 20 comprend en outre une partie évasée 28 du côté de la base 22.

La paroi latérale 26 de la portion intermédiaire 20 est contenue entre un cylindre interne à base circulaire Cint d'axe Δ et un cylindre externe Cext à base circulaire d'axe Δ, et est au contact du cylindre interne Cint et du cylindre externe Cext. Selon un mode de réalisation, Selon un mode de réalisation, la face de liaison 24 de la portion intermédiaire 20 est sensiblement perpendiculaire à l'axe Δ. La hauteur H de la portion intermédiaire 20, mesurée selon l'axe Δ, est comprise entre 10 µm et 100 µm, et est de préférence égale à environ 50 µm. Le diamètre du cylindre interne Cint est compris entre 10 µm et 3 mm, et est de préférence égale à environ 50 µm. L'écart entre le rayon du cylindre externe Cext et le rayon du cylindre interne Cint est compris entre 1 µm et 100 µm, de préférence entre 1 µm et 7 µm. Selon un mode de réalisation, le pas entre les axes Δ de piliers 15 adjacents est compris entre 20 µm et 7 mm, et est de préférence égal à environ 100 µm. Selon un mode de réalisation, excepté à proximité de la base 22 et de la face de liaison 24, la portion intermédiaire 20 a pour l'essentiel une forme cylindrique à base circulaire.

La paroi latérale 36 de la portion d'extrémité 30 est contenue entre un cylindre interne Cint' à base circulaire d'axe Δ' et un cylindre externe Cext' à base circulaire d'axe Δ', et est au contact du cylindre interne Cint' et du cylindre externe Cext'. L'axe Δ est parallèle à l'axe Δ'. Selon un mode de réalisation, l'axe Δ' est confondu avec l'axe Δ. Toutefois, l'axe Δ' peut être décalé par rapport à l'axe Δ. Le décalage entre l'axe Δ' et l'axe Δ peut être compris entre 0 µm et 6 µm. Selon un mode de réalisation, la face de liaison 32 de la portion d'extrémité 30 est sensiblement perpendiculaire à l'axe Δ. Selon un mode de réalisation, la face d'extrémité 34 de la portion d'extrémité 30 est sensiblement perpendiculaire à l'axe Δ. La hauteur H' de la portion d'extrémité 30 mesurée selon l'axe Δ' est comprise entre 10 µm et 100 µm, de préférence entre 10 µm et 40 µm, et est par exemple égale à environ 20 µm. L'écart entre le rayon du cylindre externe Cext' et le rayon du cylindre interne Cint' est compris entre 1 µm et 7 µm, de préférence entre 1 µm et 4 µm. Selon un mode de réalisation, excepté à proximité de la face de liaison 32 et de la face d'extrémité 34, la portion d'extrémité 30 a pour l'essentiel une forme cylindrique à base circulaire.

Le tronc 16 est en métal, par exemple en cuivre, en nickel, en argent, en or, ou en un alliage de ces métaux.

Selon un mode de réalisation, le pilier 15 comprend, en outre, une couche de finition 18 recouvrant la face d'extrémité 34 de la portion d'extrémité 30 du tronc 16. L'épaisseur de la couche de finition 18 est comprise entre 10 nm et 1000 nm. La couche de finition 18 est en un matériau conducteur qui améliore l'adhésion de pâte à fritter. La couche de finition 18 est par exemple en métal, notamment en or ou en argent, et comprend éventuellement une ou des couches d'accroche et/ou une ou des couches barrière, comprenant par exemple du platine (Pt), du palladium (Pd), du nickel (Ni), du titane (Ti), du chrome (Cr), et/ou du tantale (Ta), entre le matériau du tronc 16 et le matériau de la pâte à fritter qui est déposée par la suite sur le pilier 15. La couche de finition 18 permet en outre d'éviter une oxydation de la face d'extrémité 34 du pilier 15 dans le cas où le procédé d'assemblage n'est pas réalisé sous atmosphère neutre ou réductrice.

La figure 2 est une vue de côté, partielle et schématique, d'un autre mode de réalisation de la puce 10. Chaque pilier 15 de la puce 10 représentée en figure 2 comprend l'ensemble des éléments du pilier 15 de la puce 10 représentée en figure 1 à la différence que la portion d'extrémité 30 du tronc 16 ne comprend pas de partie évasée 38 du côté de la face supérieure 34.

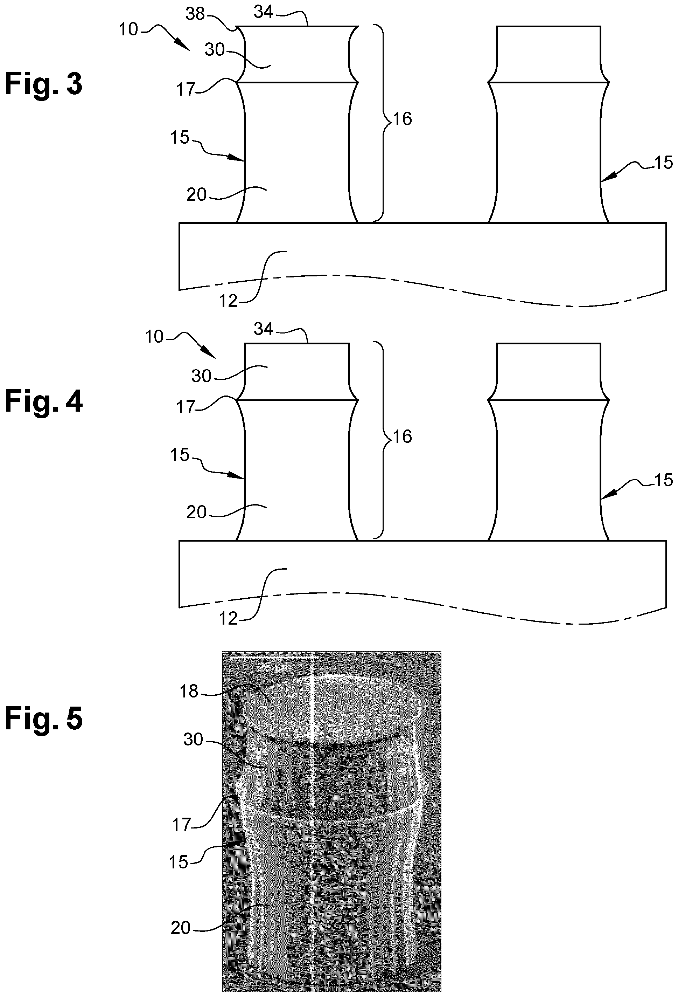

La figure 3 est une vue de côté, partielle et schématique, d'un autre mode de réalisation de la puce 10. Chaque pilier 15 de la puce 10 représentée en figure 3 comprend l'ensemble des éléments du pilier 15 de la puce 10 représentée en figure 1 à la différence que la couche de finition 18 n'est pas présente.

La figure 4 est une vue de côté, partielle et schématique, d'un autre mode de réalisation de la puce 10. Chaque pilier 15 de la puce 10 représentée en figure 4 comprend l'ensemble des éléments du pilier 15 de la puce 10 représentée en figure 2 à la différence que la couche de finition 18 n'est pas présente.

La figure 5 est une image obtenue par microscopie électronique à balayage selon une vue en perspective d'un pilier 15 selon le mode de réalisation décrit précédemment en relation avec la figure 1.

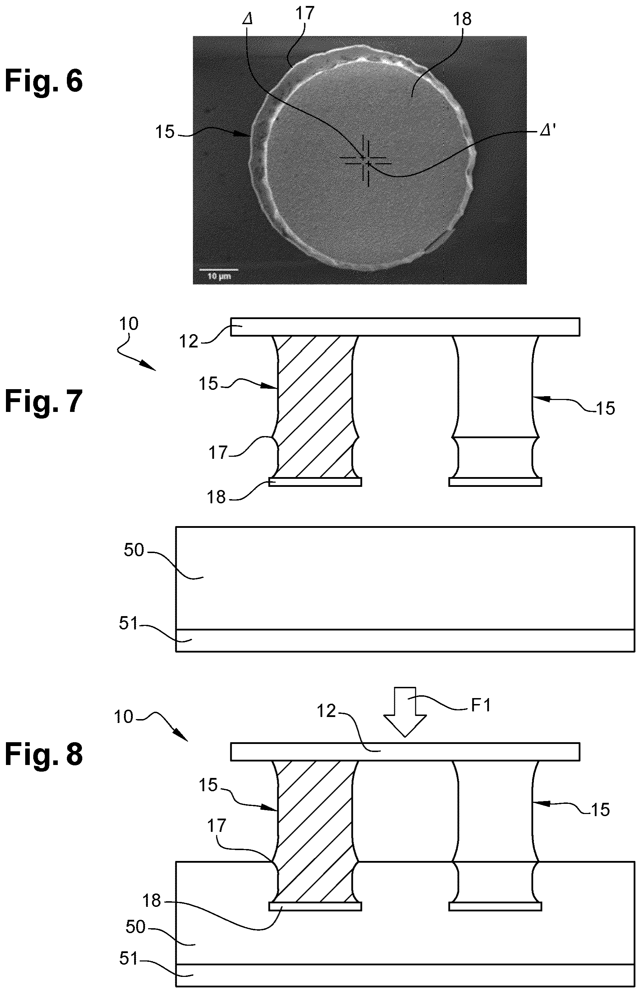

La figure 6 est une image obtenue par microscopie électronique à balayage du pilier 15 de la figure 5 vu selon l'axe Δ du côté de la couche d'accrochage 18. Dans cet exemple, l'axe Δ est décalé par rapport à l'axe Δ'.

Les figures 7 à 10 comprennent chacune une vue en coupe en partie gauche et une vue de côté en partie droite de la structure obtenue à des étapes successives d'un mode de réalisation d'un procédé d'assemblage de la puce 10 à une autre puce ou à un boîtier.

La figure 7 illustre la structure obtenue après la formation d'une couche 50 de pâte à fritter dans une cavité 52. L'épaisseur de la couche 50 de pâte est supérieure à la hauteur H' de la portion d'extrémité 30 du pilier 15. L'épaisseur de la couche 50 de pâte est comprise entre 20 µm et 200 µm, et est par exemple égale à environ 50 µm.

La puce 10 est placée au-dessus de la couche 50 de pâte par rapport à une direction verticale et à distance de la couche 50 de pâte. La couche de finition 18 de chaque pilier 15 est orientée du côté de la couche 50 de pâte. La viscosité dynamique de la couche 50 de pâte est comprise entre 20 Pa.s et 60 Pa.s. La thixotropie de la couche 50 de pâte est comprise entre 3 et 7. La couche 50 de pâte est en un matériau susceptible d'être fritté. La couche 50 de pâte comprend notamment une charge active comprenant des particules d'un matériau métallique, par exemple de l'argent, du cuivre, ou un alliage d'argent et de cuivre. La charge active peut en outre comprendre de l'or et d'autres additifs, par exemple des polymères et/ou des céramiques, ne participant pas au frittage mais facilitant les procédés de mise en oeuvre de la pâte à fritter. La proportion de la charge active dans la couche 50 de pâte est comprise de 60 % à 97 % en masse.

La figure 8 illustre la structure obtenue après l'enfoncement de la puce 10 dans la couche 50 de pâte jusqu'à ce qu'au moins la totalité de la portion d'extrémité 30 de chaque pilier 15 ait pénétré dans la couche 50 de pâte. Selon un mode de réalisation, la puce 10 est déplacée par rapport à la couche 50 de pâte au moyen d'un outil de manipulation, non représenté, par exemple selon un déplacement vertical (flèche F1). Selon un mode de réalisation, la puce 10 est mise en déplacement à une vitesse initiale donnée. Selon un mode de réalisation, un effort de résistance à la pénétration de la puce 10 dans la couche 50 de pâte est mesuré et le déplacement de la puce 10 est arrêté lorsque l'effort de résistance dépasse un seuil.

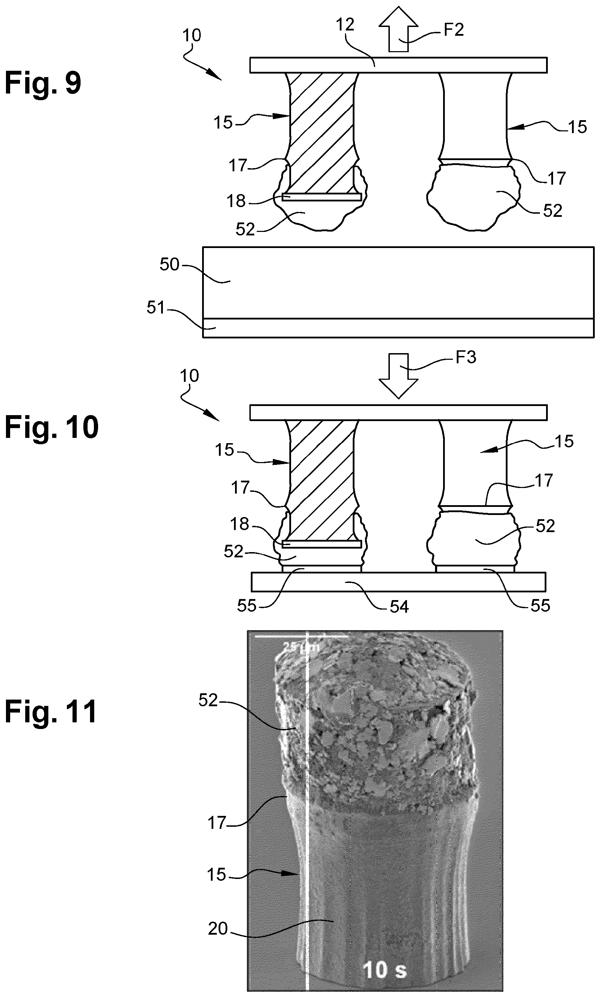

La figure 9 illustre la structure obtenue après le retrait (flèche F2) de la puce 10 hors de la couche 50 de pâte jusqu'à ce que chaque pilier 15 soit en totalité en dehors de la couche 50 de pâte. Un bloc 52 de pâte reste accroché à chaque pilier 15. La couche de finition 18 est en matériau qui favorise l'adhésion du bloc 52 de pâte. Les inventeurs ont mis en évidence que la présence de la collerette 17 fait que le volume du bloc 52 de pâte qui reste accroché au pilier 15 est plus important par rapport au cas où la collerette 17 n'est pas présente. L'épaisseur minimale du bloc 52 de pâte entre chaque pilier 15 et l'autre puce/le boîtier 54 est supérieure à 4 µm, de préférence comprise entre 7 µm et 15 µm. Une épaisseur minimale élevée peut être obtenue en raison du volume important du bloc 52 de pâte qui est emporté par chaque pilier 15.

La figure 10 illustre la structure obtenue après le dépôt de la puce 10 sur une autre puce ou un boîtier 54 de telle manière que chaque pilier 15 soit en regard d'une piste conductrice 55 de l'autre puce ou du boîtier 54, le bloc 52 de pâte contactant la piste conductrice 55. Selon un mode de réalisation, le puce 10 est posée sur l'autre puce/le boîtier 54 (flèche F3), ce qui entraîne une déformation des blocs 52 de pâte seulement sous l'action du poids de la puce 10. Selon un mode de réalisation, la puce 10 est déplacée vers l'autre puce/le boîtier 54 par un outil de manipulation, non représenté, jusqu'à ce qu'un critère soit atteint, par exemple jusqu'à ce que la distance entre le support 12 de la puce 10 et l'autre puce/le boîtier 54 atteigne une distance donnée, ou jusqu'à ce que l'effort de résistance au déplacement de la puce 10 dépasse un seuil. La déformation des blocs 52 de pâte est alors due également à l'action exercée par l'outil de manipulation sur la puce 10. L'épaisseur minimale du bloc 52 de pâte entre chaque pilier 15 et l'autre puce/le boîtier 54 après le retrait de la puce 10 hors de la couche 50 de pâte permet d'assurer que de la pâtre à fritter reste présente entre chaque pilier 15 et la piste conductrice 55 malgré une éventuelle inhomogénéité de hauteur des piliers présents sur la puce 10 et/ou une éventuelle courbure de la puce 10.

Le procédé se poursuit avec une étape de chauffage entraînant le frittage du bloc 52 de pâte et l'adhésion de la puce 10 à la puce ou au boîtier 54, par exemple à une température inférieure à 200 °C. Selon un mode de réalisation, pendant l'étape de chauffage, il n'y a pas de pression exercée sur la puce 10 ou seulement une pression inférieure à 1 MPa. Selon un mode de réalisation, la température de chauffage est comprise entre 130 °C et 300 °C, de préférence entre 150 °C et 250 °C.

La figure 11 est une image obtenue par microscopie électronique à balayage selon une vue en perspective d'un pilier 15 à l'étape décrite précédemment en relation avec la figure 9, c'est-à-dire après le retrait de la puce 10 hors de la couche 50 de pâte. La portion intermédiaire 20 est située en bas de l'image. Le bloc 52 de pâte recouvre complètement la portion d'extrémité du pilier 15.

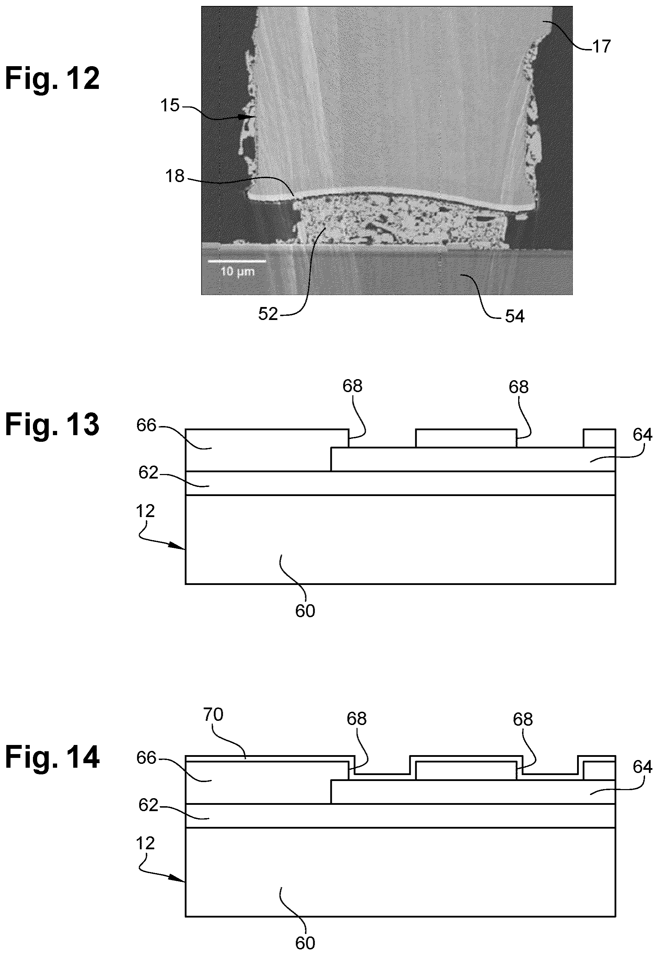

La figure 12 est une image obtenue par microscopie électronique à balayage d'une coupe d'un pilier 15 à l'étape décrite précédemment en relation avec la figure 10, c'est-à-dire après le dépôt de la puce 10 sur l'autre puce ou le boîtier 54.

Les figures 13 à 20 sont des vues en coupe, partielles et schématiques, des structures obtenues à des étapes successives d'un mode de réalisation d'un procédé de fabrication de la puce 10 de la figure 1.

La figure 13 représente la structure obtenue après la formation d'une structure d'interconnexion du support 12. Selon un mode de réalisation, le support 12 comprend un substrat 60, par exemple un substrat semiconducteur, recouvert d'une couche isolante 62. Une piste conductrice 64 s'étend sur la couche isolante 62. La piste conductrice 64 peut être connectée à des régions du substrat semiconducteur 60 par des vias conducteurs non représentés. Une couche isolante 66 s'étend sur la piste conductrice 64 et sur la couche isolante 66. Pour chaque pilier de connexion à réaliser, une ouverture traversante 68 s'étend sur toute l'épaisseur de la couche isolante 66, chaque ouverture traversante 68 exposant une partie de la piste conductrice 64. La structure d'interconnexion dépend des connexions souhaitées des piliers de connexion. Dans l'exemple illustré en figure 13, les deux piliers de connexion qui vont être formés sont connectés à la piste conductrice 34.

Le substrat 60 est par exemple un substrat en silicium, en carbure de silicium (SiC), en composes III-V, notamment le nitrure de gallium (GaN), en diamant. Le substrat 60 peut avoir une structure monocouche ou multicouches, par exemple une structure du type silicium sur isolant (SOI, sigle anglais pour Silicon On Insulator). Selon un mode de réalisation, l'épaisseur du substrat 60 est comprise entre 100 µm et 900 µm, et est par exemple égale à 200 µm. La couche isolante 62 est par exemple une couche en oxyde de silicium. Selon un mode de réalisation, l'épaisseur de la couche isolante 62 est comprise entre 100 nm et 2 µm, et est par exemple égale à 200 nm. La piste conductrice 64 comprend par exemple un empilement de couches métalliques. Selon un mode de réalisation, la piste métallique 64 peut être réalisée par le dépôt de couches métalliques pleine plaque et la gravure des couches métalliques pour former la piste métallique 64. Selon un mode de réalisation, l'épaisseur de la piste métallique 64 est comprise entre 200 nm et 2 µm, et est par exemple égale à 500 nm. Les couches métalliques de la piste métallique sont par exemple en des matériaux choisis parmi le cuivre, un alliage de cuivre, le titane, un alliage de titane, le nitrure de titane, le platine, et un alliage de platine.

La figure 14 représente la structure obtenue après la formation d'une couche métallique 70 sur la totalité de la structure obtenue à l'étape précédente. En particulier, la couche métallique 70 s'étend dans le fond de chaque ouverture 68 au contact de la piste métallique 64. Selon un mode de réalisation, l'épaisseur de la couche métallique 70 est comprise entre 10 nm et 1 µm. La couche métallique 70 peut comprendre une couche de titane ou de chrome, jouant le rôle de couche d'adhérence, et une couche de cuivre jouant le rôle de couche d'amorce pour la formation ultérieure du pilier 15.

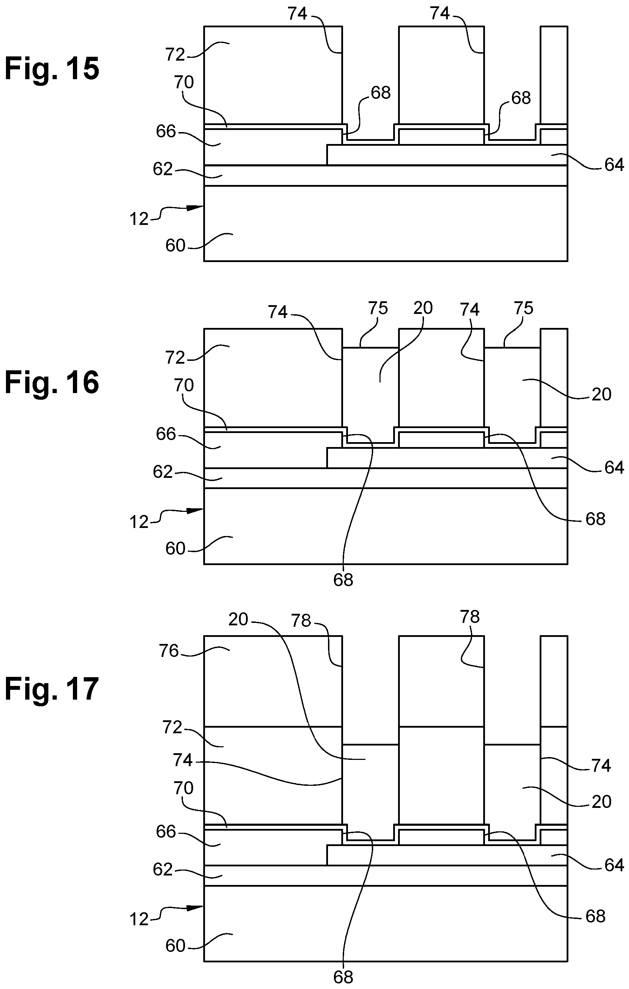

La figure 15 représente la structure obtenue après la formation d'un premier masque 72 en résine photosensible sur la couche métallique 70 comprenant des ouvertures traversantes 74, chaque ouverture traversante 74 exposant la couche métallique 70 dans l'une des ouvertures 68. Les ouvertures traversantes 74 peuvent être réalisées par des étapes de photolithographie. La hauteur du premier masque 72 est égale à la hauteur H de la portion intermédiaire 20 de chaque pilier 15.

La figure 16 représente la structure obtenue après la formation d'au moins une partie de la portion intermédiaire 20 de chaque pilier 15. Selon un mode de réalisation, la partie de la portion intermédiaire 20 de chaque pilier 15 peut ne remplir complètement l'ouverture 74 correspondante. Le matériau composant chaque pilier 15 peut être déposé par électrodéposition. La face libre 75 de la partie de la portion intermédiaire 20 peut être en retrait par rapport à la face supérieure du premier masque 72, comme cela est illustré en figure 16.

La figure 17 représente la structure obtenue après la formation d'un deuxième masque 76 en résine photosensible sur le premier masque 72 comprenant des ouvertures traversantes 78, chaque ouverture traversante 78 exposant l'une des ouvertures 74 du premier masque 72. Le deuxième masque 76 peut être en la même résine photosensible que celle utilisée pour la formation du premier masque 72, et les ouvertures traversantes 78 peuvent être réalisées par des étapes de photolithographie. La hauteur du deuxième masque de résine 78 est supérieure ou égale à la hauteur H' de la portion d'extrémité 30 de chaque pilier 15.

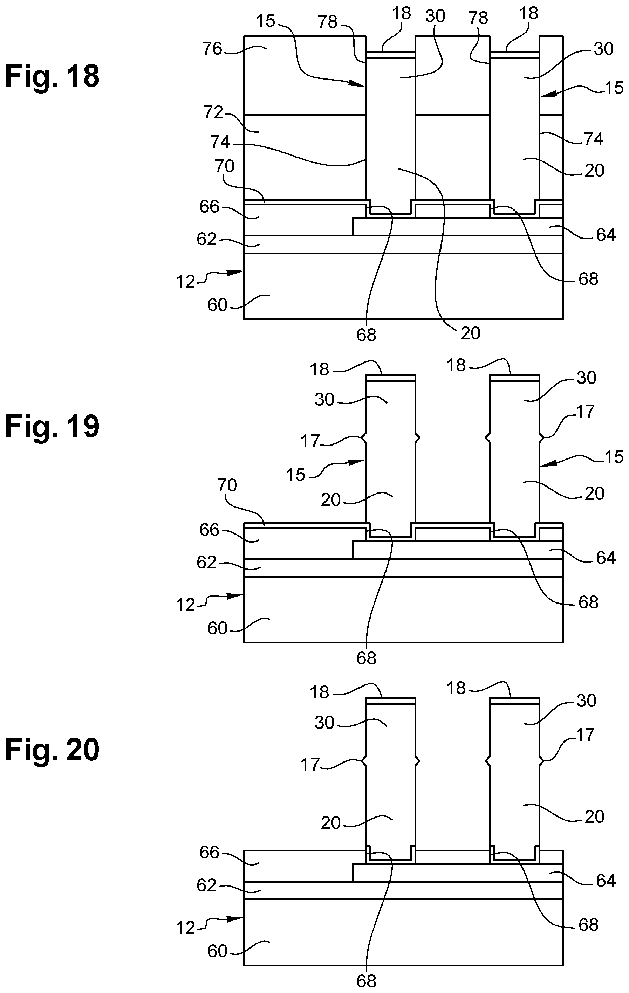

La figure 18 représente la structure obtenue après la formation du reste de la portion intermédiaire 20 de chaque pilier 15, la formation de la portion d'extrémité 30 de chaque pilier 15, et la formation de la couche de finition 18 de chaque pilier 15. Le matériau composant le tronc 16 de chaque pilier 15 peut être déposé par électrodéposition.

La figure 19 représente la structure obtenue après le retrait du deuxième masque 76 et le retrait du premier masque 72. Cela peut être réaliser par dissolution de la résine dans un solvant ou par une étape de gravure à sec. Les inventeurs ont mis en évidence que chaque pilier 15 obtenu comprend la collerette 17 située à l'interface entre le premier masque 72 et le deuxième masque 76.

La figure 20 représente la structure obtenue après le retrait de la couche métallique 70 autour des piliers 15.

Dans le mode de réalisation décrit précédemment en relation avec les figures 13 à 20, la formation du tronc 16 de chaque pilier 15 comprend deux étapes de dépôt par électrodéposition, la première étape de dépôt comprenant le remplissage partiel des ouvertures 74 du premier masque 72 et la deuxième étape de dépôt comprenant la fin du remplissage des ouvertures 74 du premier masque 72 et le remplissage total ou partiel des ouvertures 78 du deuxième masque 76. A titre de variante, la formation du tronc 16 de chaque pilier 15 comprend une seule étape de dépôt par électrodéposition comprenant le remplissage total des ouvertures 74 du premier masque 72 et le remplissage total ou partiel des ouvertures 78 du deuxième masque 76. Une telle variante peut être mise en oeuvre lorsque le facteur de forme des ouvertures 74 et 78 est compatible avec le procédé d'électrodéposition.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. Enfin, la mise en oeuvre pratique des modes de réalisation et variantes décrits est à la portée de la personne du métier à partir des indications fonctionnelles données ci-dessus.

## Revendications

1. Procédé de fabrication d'une puce électronique (10) comprenant un support (12) et des piliers de connexion (15), chaque pilier de connexion (15) comprenant un tronc (16) comportant une portion d'extrémité (30) et une portion intermédiaire (20) reliant la portion d'extrémité (30) au support (12) et comprenant une collerette (17) à la jonction entre la portion d'extrémité (30) et la portion intermédiaire (20), le procédé comprenant la formation d'un premier masque (72) en résine photosensible comprenant, pour chaque pilier de connexion (15), une première ouverture traversante (74), le dépôt du matériau composant le tronc (16) dans les premières ouvertures traversantes (74), la formation d'un deuxième masque (76) en résine photosensible comprenant une deuxième ouverture traversante (78) dans le prolongement de chaque première ouverture traversante (74), et le dépôt du matériau composant le tronc (16) dans les deuxièmes ouvertures traversantes (78).

2. Procédé de fabrication selon la revendication 1, dans lequel la hauteur (H') de la portion d'extrémité (30) est comprise entre 10 µm et 100 µm.

3. Procédé de fabrication selon la revendication 1 ou 2, dans lequel la hauteur (H) de la portion intermédiaire (20) est comprise entre 10 µm et 100 µm.

4. Procédé de fabrication selon l'une quelconque des revendications 1 à 3, dans lequel l'écart entre la dimension latérale maximale de la collerette (17) et la dimension latérale minimale de la portion d'extrémité (30) est compris entre 1 µm et 7 µm.

5. Procédé de fabrication selon l'une quelconque des revendications 1 à 4, dans lequel la portion d'extrémité (30) comprend une face d'extrémité (34) du côté opposé à la portion intermédiaire (20).

6. Procédé de fabrication selon la revendication 5, dans lequel la portion d'extrémité (30) a une forme évasée (38) du côté de la face d'extrémité (34).

7. Procédé de fabrication selon la revendication 5 ou 6, dans lequel le pilier de connexion (15) comprend une couche de finition (18) recouvrant la face d'extrémité (34).

8. Procédé de fabrication selon l'une quelconque des revendications 1 à 7, dans lequel le tronc (16) est en cuivre.

9. Procédé d'assemblage d'une puce électronique (10) fabriquée selon le procédé de fabrication selon l'une quelconque des revendications 1 à 8 à une autre puce électronique ou à un boîtier (54), comprenant la pénétration des piliers de connexion (15) dans une couche (50) de pâte à fritter au moins jusqu'à la collerette (17) de chaque pilier de connexion (15), le retrait des piliers de connexion (15) de la couche (50) de pâte à fritter, un bloc (52) de pâte à fritter restant accroché à chaque pilier de connexion (15) au moins sur la hauteur (H') de la portion d'extrémité (30), de préférence sur une hauteur égale à 50 µm, le dépôt de la puce électronique (10) sur l'autre puce électronique ou sur le boîtier (54) et le chauffage pour obtenir le frittage des blocs (52) de pâte à fritter.

10. Procédé d'assemblage selon la revendication 9, dans lequel, pendant le chauffage pour obtenir le frittage des blocs (52) de pâte à fritter, il n'y a pas de pression exercée sur la puce électronique (10).

11. Procédé d'assemblage selon la revendication 9 ou 10, dans lequel la quantité de pâte à fritter après collage, entre chaque pilier de connexion (15) et l'autre puce électronique ou le boîtier (54), est supérieure à 4 µm, de préférence comprise entre 7 µm et 15 µm.

## Patentansprüche

1. Ein Verfahren zur Herstellung eines elektronischen Chips (10), aufweisend einen Träger (12) und Verbindungssäulen (15), wobei jede Verbindungssäule (15) einen Rumpf (16) mit einem Endabschnitt (30) und mit einem Zwischenabschnitt (20) aufweist, der den Endabschnitt (30) mit dem Träger (12) koppelt, und aufweisend einen Kragen (17) an der Verbindungsstelle zwischen dem Endabschnitt (30) und dem Zwischenabschnitt (20), wobei das Verfahren Folgendes aufweist:
Ausbilden einer ersten Maske (72) aus lichtempfindlichem Harz, die für jede Verbindungssäule (15) eine erste Durchgangsöffnung (74) aufweist, Aufbringen des Materials, aus dem der Rumpf (16) besteht, in die ersten Durchgangsöffnungen (74),
Bilden einer zweiten Maske (76) aus lichtempfindlichem Harz, die eine zweite Durchgangsöffnung (78) in der Verlängerung jeder ersten Durchgangsöffnung (74) aufweist, und
Aufbringen des Materials, aus dem der Rumpf (16) besteht, in die zweiten Durchgangsöffnungen (78).

2. Das Verfahren zur Herstellung gemäß Anspruch 1, wobei die Höhe (H') des Endabschnitts (30) zwischen 10 µm und 100 µm beträgt.

3. Das Verfahren zur Herstellung gemäß Anspruch 1 oder 2, wobei die Höhe (H) des Zwischenabschnitts (20) zwischen 10 µm und 100 µm beträgt.

4. Das Verfahren zur Herstellung gemäß einem der Ansprüche 1 bis 3, wobei die Differenz zwischen der maximalen seitlichen Abmessung des Kragens (17) und der minimalen seitlichen Abmessung des Endabschnitts (30) zwischen 1 µm und 7 µm beträgt.

5. Das Verfahren zur Herstellung gemäß einem der Ansprüche 1 bis 4, wobei der Endabschnitt (30) eine Endfläche (34) auf der dem Zwischenabschnitt (20) gegenüberliegenden Seite aufweist.

6. Das Verfahren zur Herstellung gemäß Anspruch 5, wobei der Endabschnitt (30) auf der Seite der Endfläche (34) eine aufgeweitete Form (38) aufweist.

7. Das Verfahren zur Herstellung gemäß Anspruch 5 oder 6, wobei die Verbindungssäule (15) eine die Endfläche (34) bedeckende Endschicht (18) aufweist.

8. Das Verfahren zur Herstellung gemäß einem der Ansprüche 1 bis 7, wobei der Rumpf (16) aus Kupfer besteht.

9. Ein Verfahren zum Zusammenbau eines gemäß dem Verfahren zur Herstellung gemäß einem der Ansprüche 1 bis 8 hergestellten elektronischen Chips (10) mit einem anderen elektronischen Chip oder mit einer Einheit bzw. Baugruppe (54), aufweisend:
Eindringen der Verbindungssäulen (15) in eine Schicht (50) aus Sinterpaste mindestens bis zum Kragen (17) jeder Verbindungssäule (15),
Entfernen der Verbindungssäulen (15) aus der Schicht (50) aus Sinterpaste, wobei ein Block (52) aus Sinterpaste an jeder Verbindungssäule (15) mindestens über die Höhe (H') des Endabschnitts (30), vorzugsweise über eine Höhe von 50 µm, haften bleibt,
Aufbringen des elektronischen Chips (10) auf den anderen elektronischen Chip oder auf die Einheit (54), und
Erhitzen, um ein Sintern der Blöcke (52) aus Sinterpaste zu erhalten.

10. Das Verfahren zum Zusammenbau gemäß Anspruch 9, wobei während des Erhitzens, um ein Sintern der Blöcke (52) aus Sinterpaste zu erhalten, kein Druck auf den elektronischen Chip (10) ausgeübt wird.

11. Das Verfahren zum Zusammenbau gemäß Anspruch 9 oder 10, wobei die Menge der nach dem Bonding zu sinternden Paste zwischen jeder Verbindungssäule (15) und dem anderen Chip oder der Einheit (54) größer als 4 µm, vorzugsweise zwischen 7 µm und 15 µm, beträgt.

## Claims

1. A method of manufacturing an electronic chip (10) comprising a support (12) and connection pillars (15), each connection pillar (15) comprising a trunk (16) comprising an end portion (30) and an intermediate portion (20) coupling the end portion (30) to the support (12) and comprising a collar (17) at the junction between the end portion (30) and the intermediate portion (20), the method comprising forming a first mask (72) of photosensitive resin comprising, for each connection pillar (15), a first through opening (74), depositing the material making up the trunk (16) in the first through openings (74), forming a second mask (76) of photosensitive resin comprising a second through opening (78) in the extension of each first through opening (74), and depositing the material making up the trunk (16) in the second through openings (78).

2. The method of manufacturing according to claim 1, wherein the height (H') of the end portion (30) is between 10 µm and 100 µm.

3. The method of manufacturing according to claim 1 or 2, wherein the height (H) of the intermediate portion (20) is between 10 µm and 100 µm.

4. The method of manufacturing according to any one of claims 1 to 3, wherein the difference between the maximum lateral dimension of the collar (17) and the minimum lateral dimension of the end portion (30) is between 1 µm and 7 µm.

5. The method of manufacturing according to any one of claims 1 to 4, wherein the end portion (30) comprises an end face (34) on the side opposite the intermediate portion (20).

6. The method of manufacturing according to claim 5, wherein the end portion (30) has a flared shape (38) on the side of the end face (34).

7. The method of manufacturing according to claim 5 or 6, wherein the connection pillar (15) comprises a finishing layer (18) covering the end face (34).

8. The method of manufacturing according to any one of claims 1 to 7, wherein the trunk (16) is made of copper.

9. A method of assembling an electronic chip (10) manufactured according to the method of manufacturing according to any one of claims 1 to 8 to another electronic chip or to a package (54), comprising penetrating the connection pillars (15) into a layer (50) of sinter paste at least up to the collar (17) of each connection pillar (15), removing the connection pillars (15) from the layer (50) of sinter paste, a block (52) of sinter paste remaining attached to each connection pillar (15) at least over the height (H') of the end portion (30), preferably over a height equal to 50 µm, depositing the electronic chip (10) on the other electronic chip or on the package (54), and heating to obtain sintering of the blocks (52) of sinter paste.

10. The method of assembling according to claim 9, wherein, during heating to obtain sintering of the blocks (52) of sinter paste, there is no pressure exerted on the electronic chip (10).

11. The method of assembling according to claim 9 or 10, wherein the amount of paste to be sintered after bonding, between each connection pillar (15) and the other chip or package (54), is greater than 4 µm, preferably between 7 µm and 15 µm.
